# EUROPEAN PATENT APPLICATION

(11) **EP 2 402 111 A2**
(43) Date of publication of application: **04.01.2012**
(21) Application number: 11165400.0
(22) Date of filing: 10.05.2011
(51) Int. Cl.: B23K 26/16, B23K 26/40

(54) **Thin film removal apparatus**

(30) Priority: 30.06.2010 JP 2010149325
(71) Applicant: Mitsuboshi Diamond Industrial Co., Ltd., Suita-city, Osaka 564-0044 (JP)
(72) Inventor: Akai, Toshio, Suita, Osaka 564-0044 (JP); Takahashi, Yoshimi, Suita, Osaka 564-0044 (JP)
(74) Representative: TBK

(57) **Abstract**

A radiation part 40 is moved relative to a holding unit 10 while radiating a laser beam 40a. A suction part 50, together with the radiation part 40, is moved relative to the holding unit 10 while the positional relationship between the suction part 50 and the radiation part 40 is maintained. Thereby, the laser beam 40a radiated from the radiation part 40 is incident on an insulating substrate 5 from the lower side of the insulating substrate 5, and reaches the film 6 formed on the insulating substrate 5. A component material of the film 6 removed from the insulating substrate 5 by the laser beam 40a is, after the removal, quickly sucked by the suction part 50 provided directly above the radiation part 40.

## Description

### BACKGROUND OF THE INVENTION

### Field of the Invention

The present invention relates to a removal apparatus that removes a film from a light-transmitting insulating substrate (hereinafter simply referred to as a "insulating substrate") formed of an insulator, such as an organic electro luminescence display glass substrate, a liquid crystal display glass substrate, a resin substrate, a photomask glass substrate, an optical disk substrate, and a solar-cell glass substrate.

### Description of the Background Art

Conventionally known is a technique of removing a film formed on an insulating substrate by irradiating the film existing on the insulating substrate with a laser beam (for example, Japanese Patent Application Laid-Open No. 2001-111078; Japanese Patent Application Laid-Open No. 2009-082974; and Japanese Patent Application Laid-Open No. 2010-092893). Here, in techniques disclosed in Japanese Patent Application Laid-Open No. 2001-111078, Japanese Patent Application Laid-Open No. 2009-082974, and Japanese Patent Application Laid-Open No. 2010-092893, a film existing on an insulating substrate is removed by:
(1) inverting the insulating substrate such that a film surface thereof (one of main surfaces of the insulating substrate where the film is formed) faces downward; and
(2) irradiating the film with a laser beam that has been incident on a surface (an upper main surface of the insulating substrate) opposite to the film surface and then transmitted through the insulating substrate.

In this manner, the techniques of Japanese Patent Application Laid-Open No. 2001-111078, Japanese Patent Application Laid-Open No. 2009-082974, and Japanese Patent Application Laid-Open No. 2010-092893 are based on the assumption that the insulating substrate is inverted such that the film surface faces downward prior to removing the film formed on the surface. In this case, a holder for the insulating substrate holds a peripheral edge portion of the inverted insulating substrate, in order to prevent the film formed on the film surface from being damaged.

Accordingly, if the size of the insulating substrate is increased, an influence of deflection of the insulating substrate is larger. As a result, the laser beam cannot be successfully collected to the film formed on the insulating substrate, which causes a problem that the film cannot be successfully removed.

Therefore, an object of the present invention is to provide a removal apparatus capable of successfully removing a film formed on an insulating substrate.

### SUMMARY OF THE INVENTION

The present invention is directed to a removal apparatus that removes a film from a light-transmitting insulating substrate.

According to the present invention, the removal apparatus includes: a holding unit for holding the insulating substrate such that the film faces upward; a removal suction unit for removing and sucking the film from the insulating substrate; and a driving unit for moving the removal suction unit relative to the holding unit. The removal suction unit includes: a radiation part provided below the insulating substrate held by the holding unit, the radiation part radiating a laser beam to the film formed on the insulating substrate; and a suction part provided above the insulating substrate held by the holding unit and directly above the radiation part, the suction part sucking a component material of the film removed by the radiation of the laser beam. The driving unit moves the radiation part and the suction part relative to the holding unit while maintaining the positional relationship between the radiation part and the suction part.

The size and the manufacturing cost of the removal apparatus can be reduced without providing a large-size suction mechanism near the holding unit.

Preferably, the removal suction unit further includes a mounting part having the radiation part and the suction part mounted thereon, and the driving unit supplies driving force to the mounting part, thereby moving the radiation part and the suction part relative to the holding unit.

The removal and the suction of the film existing on the insulating substrate can be performed more successfully.

Preferably, the central axis of the radiation part and the central axis of the suction part are substantially coincident with each other.

The removal and the suction of the film existing on the insulating substrate can be performed more successfully.

Preferably, the removal apparatus further includes a cleaning nozzle provided in a retracted position of the removal suction unit, the cleaning nozzle supplying a clean gas to the radiation part.

The removal of the film by means of the laser beam can be kept in a good state.

These and other objects, features, aspects and advantages of the present invention will become more apparent from the following detailed description of the present invention when taken in conjunction with the accompanying drawings.

### BRIEF DESCRIPTION OF THE DRAWINGS

FIG. 1 is a perspective view showing an exemplary configuration of a removal apparatus according to a preferred embodiment of the present invention;
FIG. 2 is a perspective view showing the exemplary configuration of the removal apparatus according to the preferred embodiment of the present invention; and
FIG. 3 is a front elevational view showing an exemplary configuration of a removal suction unit.

### EMBODIMENT FOR CARRYING OUT THE INVENTION

In the following, a preferred embodiment of the present invention will be described in detail with reference to the accompanying drawings.

### <1. Configuration of Removal Apparatus>

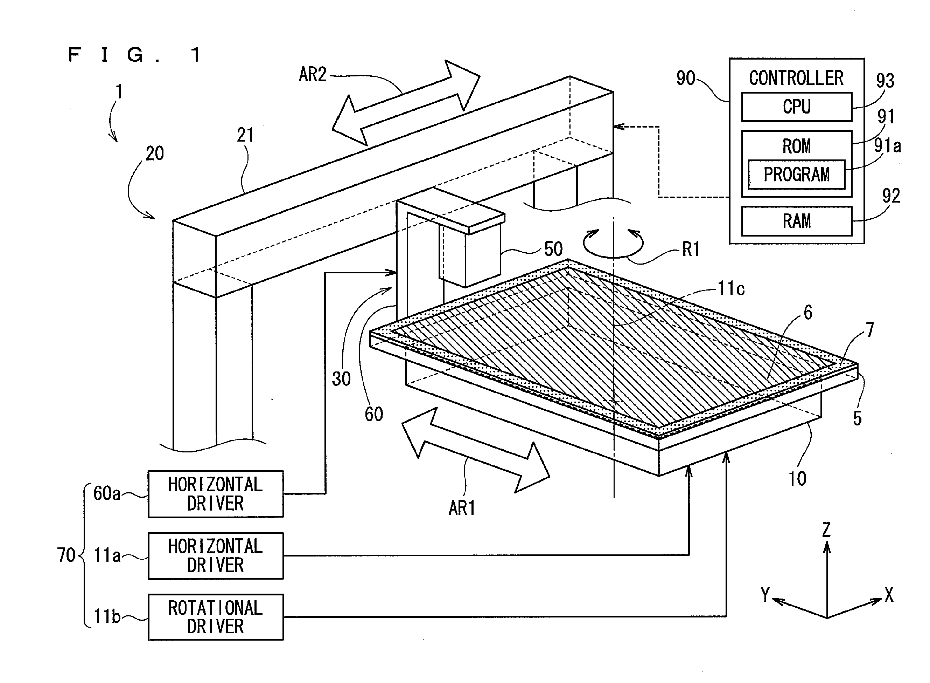

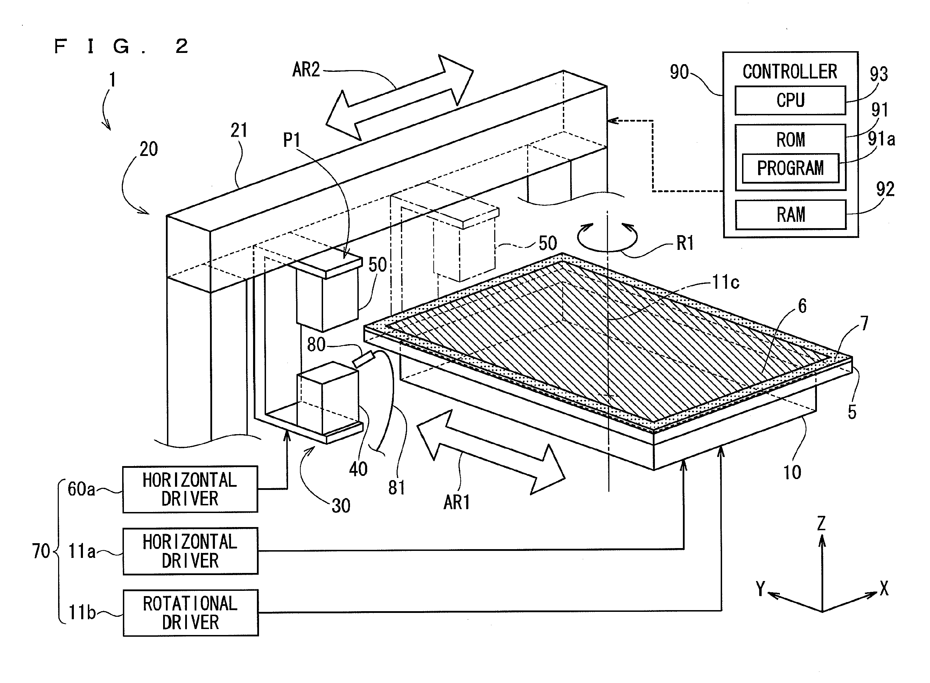

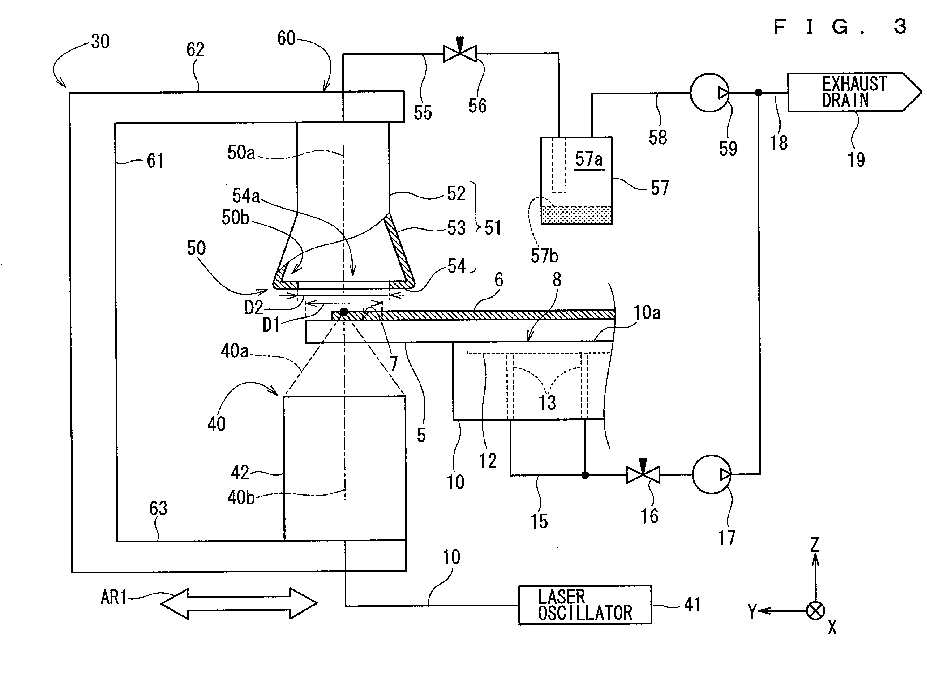

FIGS. 1 and 2 are perspective views showing an exemplary configuration of a removal apparatus 1 according to a preferred embodiment of the present invention. FIG. 3 is a front elevational view showing an exemplary configuration in the vicinity of a removal suction unit 30. Here, the removal apparatus 1 removes a film 6 from an insulating substrate 5 to expose a surface of the insulating substrate 5, thus performing a deletion process on a portion near a peripheral edge of the insulating substrate 5. As shown in FIGS. 1 and 2, the removal apparatus 1 mainly includes a holding unit 10, a bridge structure 20, a removal suction unit 30, a cleaning nozzle 80, and a controller 90.

To clarify the directional relationship among these parts, FIGS. 1 to 3 additionally show an XYZ orthogonal coordinate system whose Z-axis direction represents the vertical direction and whose XY plane represents a horizontal plane.

The holding unit 10 holds the insulating substrate 5 such that the film 6 faces upward (and more specifically, the holding unit 10 holds the insulating substrate 5 within a holding range 8 which is nearer to the center than a removal range 7 is). As shown in FIGS. 1 to 3, the holding unit 10 mainly includes a horizontal driver 11a and a rotational driver 11b. As shown in FIG. 3, the holding unit 10 has suction grooves 12 and through holes 13.

The horizontal driver 11a moves the holding unit 10 in a direction of the arrow \AR1 (a positive or negative direction in the Y-axis; a first horizontal direction). The rotational driver 11b rotates the holding unit 10 around a rotation axis 11c in a direction of the arrow R1 (a rotation direction). Thus, the holding unit 10 can move any one side of the four sides of the insulating substrate 5 to the vicinity of the removal suction unit 30. Then, the removal range 7 (see FIG. 3) is set along this one side.

A plurality of suction grooves 12 (only one of which is shown in FIG. 3 for the sake of convenience) are recesses formed on a holding surface 10a of the holding unit 10. The suction grooves 12, each of which is formed so as to extend substantially linearly along the X-axis or the Y-axis, are arranged in a grid pattern.

A plurality of through holes 13 (only one of which is shown in FIG. 3 for the sake of convenience) are vertical holes extending from the respective suction grooves 12 to a lower face of the holding unit 10. For example, the through holes 13 may be connected at crosspoints (grid points) where the plurality of suction grooves 12 intersect one another.

As shown in FIG. 3, each of the through holes 13 is communicably connected to an exhaust drain 19 via piping 15, a valve 16, a pump 17, and common piping 18.

Thus, opening the valve 16 and operating the pump 17 cause an atmosphere near the lower side of the insulating substrate 5 and an atmosphere in the suction groove 12 to be exhausted. As a result, the insulating substrate 5 is sucked to and held by the holding surface 10a of the holding unit 10.

The bridge structure 20 is a structure arranged so as to extend over the holding unit 10. As shown in FIGS. 1 and 2, the bridge structure 20 has a unit supporter 21 extending in a direction (indicated by the arrow AR2) perpendicular to a moving direction (indicated by the arrow AR1) of the holding unit 10.

As shown in FIG. 3, the removal suction unit 30 removes the film 6 from the insulating substrate 5 in the removal range 7 by a laser beam 40a while moving along the unit supporter 21 of the bridge structure 20. The removal suction unit 30 sucks (dust attraction) a component material of the film 6 emitted from the upper side of the insulating substrate 5. Details of the removal suction unit 30 will be described later.

For example, the cleaning nozzle 80 supplies a clean gas (for example, nitrogen gas) to an optical system such as a scanner 42 (see FIG. 3), thereby removing dust and the like adhering to the radiation part 40, to clean the radiation part 40. The cleaning nozzle 80 is connected to a clean-gas supply source (not shown) via piping 81. As shown in FIG. 2, the cleaning nozzle 80 is provided in a retracted position P1 of the removal suction unit 30.

This can keep the radiation part 40 clean even in a case where the laser beam 40a is emitted from the lower side of the insulating substrate 5. Thus, the removal of the film 6 by means of the laser beam 40a can be kept in a good state.

For example, the controller 90 controls movement and rotation operations of the holding unit 10 and movement, radiation, and sucking operations of the removal suction unit 30, and also performs data calculation. As shown in FIGS. 1 and 2, the controller 90 mainly includes a ROM 91, a RAM 92, and a CPU 93.

The ROM (Read Only Memory) 91 is a so-called non-volatile storage section, and stores a program 91a, for example. A flash memory which is a readable/writable non-volatile memory may be used as the ROM 91.

The RAM (Random Access Memory) 92 is a volatile storage section, and stores data used for calculation in the CPU 93, for example. The CPU (Central Processing Unit) 93 executes controlling (for example, controlling of the sucking operation performed by the removal suction unit 30) and data processing in accordance with the program 9 1 a stored in the ROM 91.

### <2. Configuration of Removal Suction Unit>

Here, a hardware configuration of the removal suction unit 30 will be described. As shown in FIG. 3, the removal suction unit 30 mainly includes the radiation part 40, a suction part 50, and a mounting part 60.

As shown in FIG. 3, the radiation part 40 is provided below the insulating substrate 5 held by the holding unit 10, and radiates the laser beam 40a (having a laser spot diameter of approximately 150 µm, for example) to the film 6 formed on the insulating substrate 5. The film 6 irradiated with the laser beam 40a is brought into an atomic state, a molecular state, or a plasma state, so that fine particles of the component material of the film 6 are emitted from the upper side of the insulating substrate 5. As shown in FIG. 3, the radiation part 40 mainly includes a laser oscillator 41, the scanner 42, and an optical fiber 43.

The laser oscillator 41 emits a laser beam based on a drive signal sent from the controller 90. In this preferred embodiment, a green laser (semiconductor-laser-excited solid-state laser (diode-pumped solid-state laser) having a wavelength of 532 nm) having a high relative luminous efficiency may be used as the laser oscillator 41. The laser beam emitted from the laser oscillator 41 is guided to the scanner 42 through the optical fiber 43.

The scanner 42 changes a direction of radiation of the laser beam 40a, thereby scanning the film 6 with the laser beam 40a. Here, the scanner 42 of this preferred embodiment has two mirrors (not shown) whose rotation axes extend in directions perpendicular to each other. Accordingly, by adjusting the amount of rotation of each mirror, the scanner 42 can swing the laser beam 40a in a desired direction.

The suction part 50 sucks the component material of the film 6 emitted from the upper side of the insulating substrate 5. As shown in FIG. 3, the suction part 50 is provided above the insulating substrate 5 held by the holding unit 10, and positioned directly above the radiation part 40. The suction part 50 has a suction nozzle 51.

As shown in FIG. 3, the suction nozzle 51 is a hollow tubular member extending in the vertical direction (Z-axis direction). As shown in FIG. 3, the suction nozzle 51 mainly includes a straight portion 52, a broadening portion 53, and a flat portion 54. As shown in FIG. 3, the suction nozzle 51 is communicably connected to the exhaust drain 19 via piping 55, a valve 56, a separator 57, piping 58, and a pump 59.

The straight portion 52, which is arranged at the upper side of the broadening portion 53, is a cylindrical member extending straight in the vertical direction. As shown in FIG. 3, the inner diameter of the straight portion 52 is substantially constant at any position thereof along the vertical direction (Z-axis direction). In the same manner, the outer diameter of the straight portion 52 is also constant at any position thereof along the vertical direction.

As shown in FIG. 3, the broadening portion 53, which is provided at the lower side of the straight portion 52, has a shape of circular truncated cone. The inner diameter and the outer diameter of the broadening portion 53 increase from the straight portion 52 side toward the flat portion 54 side.

The flat portion 54 is a ring-shaped flat plate provided on the lower side of the broadening portion 53. An opening 54a of the flat portion 54 is used as a suction port for sucking the component material of the film 6. Thus, a solid of the film 6 solidified at the suction nozzle 51 is captured in a capture space 50b sandwiched between the broadening portion 53 and the flat portion 54. This can prevent the solid of the solidified film 6 from adhering to the insulating substrate 5.

As shown in FIG. 3, the suction nozzle 51 is communicably connected to the exhaust drain 19 via the piping 55, the valve 56, the separator 57, the piping 58, and the pump 59. Opening the valve 56 and operating the pump 59 cause the component material of the film 6 existing in the removal range 7 to be exhausted together with an atmosphere near the removal range 7. Thereby, a region near the upper side of the insulating substrate 5 can be kept clean.

The separator 57 separates the component material of the film 6 from a gas containing the component material. For example, the component material of the film 6 sucked by the suction nozzle 51 is guided into an enclosed space 57a of the separator 57 through the piping 55 and the valve 56. The component material of the film 6 guided into the enclosed space 57a is solidified into a solid 57b, and left within the enclosed space 57a. Therefore, clean air not containing the component material of the film 6 is exhausted from the separator 57 to the exhaust drain 19.

As shown in FIGS. 1 and 2, the mounting part 60 is a movable member that moves along a longitudinal direction (indicated by the arrow AR2) of the bridge structure 20. The radiation part 40 and the suction part 50 are mounted on the mounting part 60. As shown in FIG. 3, the mounting part 60 mainly includes a horizontal driver 60a, a support member 61, and upper and lower brackets 62 and 63.

The support member 61 is a column-like member extending in the vertical direction. The upper and lower brackets 62 and 63 have cantilever shapes, and are provided near upper and lower ends of the support member 61, respectively. The suction part 50 and the radiation part 40 are fixed to free ends of the upper and lower brackets 62 and 63, respectively.

Thus, the radiation part 40 and the suction part 50 fixed to the mounting part 60 are movable in the direction of the arrow AR2 (see FIGS. 1 and 2) along the peripheral edge of the insulating substrate 5 having a rectangular shape in a plan view. That is, the radiation part 40 and the suction part 50 are integrally moved relative to the holding unit 10. Therefore, the removal and the suction of the film 6 on the insulating substrate 5 can be performed more successfully.

As shown in FIG. 3, the radiation part 40 and the suction part 50 are mounted on the mounting part 60 such that their central axes 40b and 50a can be coincident with each other. This enables the suction part 50 to more quickly suck the component material of the film 6 removed from the insulating substrate 5. Therefore, the removal and the suction of the film 6 on the insulating substrate 5 can be performed more successfully.

The horizontal driver 60a supplies driving force to the support member 61 of the mounting part 60. Thereby, the support member 61 and the upper and lower brackets 62 and 63 can be moved in the direction of the arrow AR2 (a positive or negative direction in the X-axis; a second horizontal direction).

In this manner, the horizontal driver 60a, and the horizontal driver 11a and the rotational driver 11b of the holding unit 10 can move the radiation part 40 and the suction part 50 relative to the holding unit 10 while maintaining the positional relationship between the radiation part 40 and the suction part 50. That is, the horizontal driver 11a, the rotational driver 11b, and the horizontal driver 60a can be used as a driving unit 70. As described above, the scanner 42 can change the direction of radiation of the laser beam 40a to thereby scan the film 6 with the laser beam 40a.

Thus, the driving unit 70 can move the radiation part 40 and the suction part 50 along the peripheral edge of the insulating substrate 5, while the scanner 42 is performing scanning with the laser beam 40a running back and forth in the direction of the arrow AR1.

Therefore, the radiation part 40 can radiate the laser beam 40a so as to remove the film 6 from the removal range 7 (for example, a scanning width D1 is 5 to 10 mm) which is near the peripheral edge of the insulating substrate 5, thus exposing the surface of the insulating substrate 5.

A manner of movement caused by the horizontal driver 11 a, the rotational driver 11b, and the horizontal driver 60a is exemplified by:
(1) moving only the radiation part 40 and the suction part 50;
(2) moving only the holding unit 10; and
(3) moving both of the radiation part 40 and the suction part 50, and the holding unit 10.

An opening width D2 of the suction nozzle 51 is set larger than the removal range 7. This enables the suction part 50 to more successfully suck the component material of the film 6.

### <3. Advantageous Effects of Removal Apparatus of This Preferred Embodiment>

In the removal apparatus 1 of this preferred embodiment, the radiation part 40 is moved relative to the holding unit 10 while radiating the laser beam 40a. The suction part 50, together with the radiation part 40, is moved relative to the holding unit 10 while the positional relationship between the suction part 50 and the radiation part 40 is maintained.

Thereby, the laser beam 40a radiated from the radiation part 40 is incident on the insulating substrate 5 from the lower side of the insulating substrate 5, to reach the film 6 formed on the insulating substrate 5. The component material of the film removed from the insulating substrate 5 by the laser beam 40a is, after the removal, quickly sucked by the suction part 50 provided directly above the radiation part 40.

In this manner, the radiation part 40 and the suction part 50 are integrally moved while the suction part 50 is provided directly above the radiation part 40. Thereby, the component material of the film 6 removed from the insulating substrate 5 can be successfully sucked. Thus, it is not necessary to provide a large-size suction mechanism near the holding unit 10. Therefore, the size and the manufacturing cost of the removal apparatus 1 can be reduced.

The removal apparatus 1 of this preferred embodiment can remove the film 6 existing on the insulating substrate 5 without inverting the insulating substrate 5. That is, the removal apparatus 1 of this preferred embodiment can suppress an influence of deflection of the insulating substrate 5 which may otherwise be caused by the insulating substrate 5 being held in an inverted state. This can successfully collect the laser beam 40a on the film 6, so that the film 6 can be successfully removed.

### <4. Modification>

While a preferred embodiment of the present invention has been described above, the present invention is not limited to the above-described preferred embodiment, and various modifications may be made thereto.

In this preferred embodiment, the size of the holding surface 10a of the holding unit 10 is smaller than the size of the main surface of the insulating substrate 5. However, this is not limitative. If the material of the holding unit 10 is transparent to the laser beam 40a, the size of the holding surface 10a of the holding unit 10 may be equal to or larger than the size of the main surface of the insulating substrate 5. In this case, the laser beam 40a is incident on the holding unit 10 from the lower side of the holding unit 10, and reaches the film 6 through the insulating substrate 5.

While the invention has been shown and described in detail, the foregoing description is in all aspects illustrative and not restrictive. It is therefore understood that numerous modifications and variations can be devised without departing from the scope of the invention.

A radiation part 40 is moved relative to a holding unit 10 while radiating a laser beam 40a. A suction part 50, together with the radiation part 40, is moved relative to the holding unit 10 while the positional relationship between the suction part 50 and the radiation part 40 is maintained. Thereby, the laser beam 40a radiated from the radiation part 40 is incident on an insulating substrate 5 from the lower side of the insulating substrate 5, and reaches the film 6 formed on the insulating substrate 5. A component material of the film 6 removed from the insulating substrate 5 by the laser beam 40a is, after the removal, quickly sucked by the suction part 50 provided directly above the radiation part 40.

## Claims

1. A removal apparatus that removes a film from a light-transmitting insulating substrate, said apparatus comprising:
a holding unit for holding said insulating substrate such that said film faces upward;
a removal suction unit for removing and sucking said film from said insulating substrate; and
a driving unit for moving said removal suction unit relative to said holding unit,
wherein
said removal suction unit includes:
a radiation part provided below said insulating substrate held by said holding unit, said radiation part radiating a laser beam to said film formed on said insulating substrate; and
a suction part provided above said insulating substrate held by said holding unit and directly above said radiation part, said suction part sucking a component material of said film removed by the radiation of said laser beam,
said driving unit moves said radiation part and said suction part relative to said holding unit while maintaining the positional relationship between said radiation part and said suction part.

2. The removal apparatus according to claim 1, wherein
said removal suction unit further includes a mounting part having said radiation part and said suction part mounted thereon,
said driving unit supplies driving force to said mounting part, thereby moving said radiation part and said suction part relative to said holding unit.

3. The removal apparatus according to claim 1 or 2, wherein
the central axis of said radiation part and the central axis of said suction part are substantially coincident with each other.

4. The removal apparatus according to any one of claims 1 to 3, further comprising
a cleaning nozzle provided in a retracted position of said removal suction unit, said cleaning nozzle supplying a clean gas to said radiation part.
